# EUROPÄISCHE PATENTSCHRIFT

(11) **EP 3 863 382 B1**
(45) Veröffentlichungstag und Bekanntmachung des Hinweises auf die Patenterteilung: **07.05.2025**
(21) Anmeldenummer: 21154478.8
(22) Anmeldetag: 01.02.2021
(51) Int. Cl.: H05B 47/18

(54) **TESTGERÄT UND VERFAHREN ZUR ÜBERPRÜFUNG EINER LEUCHTE**
TEST APPARATUS AND METHOD FOR TESTING A LIGHT
APPAREIL D'ESSAI ET PROCÉDÉ DE VÉRIFICATION D'UN LUMINAIRE

(30) Priorität: 05.02.2020 DE 102020102865
(43) Veröffentlichungstag der Anmeldung: 11.08.2021
(73) Patentinhaber: Zumtobel Lighting GmbH, 6850 Dornbirn (AT)
(72) Erfinder: BLOCK, Steffen, 6850 Dornbirn (AT); STEFFENS, Thomas, 6850 Dornbirn (AT)
(74) Vertreter: Thun, Clemens

(56) Entgegenhaltungen:
- WO-A1-2010/043263
- WO-A1-2013/126965
- DE-A1- 102007 051 143
- DE-A1- 102007 055 164
- DE-A1- 102016 205 683
- DE-B4- 102007 055 164

## Beschreibung

Die Erfindung betrifft ein Verfahren zur Überprüfung einer Leuchte hinsichtlich des Vorhandenseins und/oder der Funktionalität von Komponenten der Leuchte, sowie ein Testgerät zur Durchführung dieser Überprüfung.

Aus der bisher angewandten Praxis sind Verfahren zur Überprüfung einer Leuchte hinsichtlich des Vorhandenseins und/oder der Funktionalität von Komponenten der Leuchte bekannt, wobei die Leuchte unterschiedliche Komponenten, wie eine Steuereinheit, Leuchtmittel mit Leuchtmitteltreiber, ein Bussystem, sowie zumindest ein Sensor und/oder zumindest ein Bedienelement aufweist. Bisher muss hierzu der zumindest ein Sensor und/oder das zumindest eine Bedienelement im verbauten Zustand bestimmten Bedingungen ausgesetzt werden, wobei im Anschluss daran zu beobachten ist, wie die Leuchte auf die durch den Sensor ausgesandten Steuerinformationen reagiert. Auf Basis der Reaktion der Leuchte kann dann rückgeschlossen werden, ob einzelne Komponenten vorhanden sind und/oder funktionieren.

Dieser bisherige Überprüfungsvorgang ist mit einem verhältnismäßig hohen Aufwand verbunden, da bisher jede Leuchte jeweils manuell zu überprüfen ist, wobei üblicherweise eine Fachkraft mit einer entsprechenden Qualifikation benötigt wird, um die zu überprüfende Leuchte während des Durchprüfens zu bedienen. Zudem ist es bisher üblich das zumindest ein spezielles Bediengerät bei der Überprüfung der Leuchte verwendet wird, um die Funktionalität der Komponenten der Leuchte, respektive die Funktionalität der Leuchte, zu bestimmen, wobei die Fachkraft ebenfalls zur Handhabung des Bediengeräts ausgebildet sein muss, wobei in bisher bekannten Verfahren das Bediengerät mit einer Steuereinheit einer Leuchte in aufwändiger Weise gekoppelt wird, um den Leuchten-Prüfvorgang durchzuführen. Ebenso ist es in bisherigen Überprüfungsvorgängen üblich, dass einzelne Bedienelemente einer Leuchte und/oder Sensoren einer Leuchte einzeln und manuell durch die Fachkraft bedient und/oder ausgelöst werden, sodass basierend auf der Reaktion der Leuchte erkannt wird, ob die jeweilige Komponente der Leuchte, respektive die gesamte Leuchte funktionsfähig ist. Daher ist die bisherige Praxis für einen Leuchten-Prüfvorgang zeit- und kostenaufwendig.

Aus der DE 10 2007 055 146 A1 ist eine Betriebsgerät für mindestens ein Leuchtmittel bekannt, welches eine physikalische Schnittstelle zum Anschluss eines Lichtsensors und zur Eingabe von Lichtsensor-Daten in einem ersten Modus, wobei diese Schnittstelle in einen zweiten Modus zur Ausgabe von Daten umschaltbar ist. Hierbei kann ein Auslesegerät an die physikalische Schnittstelle angeschlossen werden, wobei dann vom Auslesegerät eine Versorgungsspannung an der physikalischen Schnittstelle angelegt wird, welche dann vom Betriebsgeräts moduliert und anschließend vom Auslesegerät demoduliert und ausgewertet werden kann.

Die WO 2013/126965 A1 beschreibt ein Verfahren zur Inbetriebnahme eines Notbeleuchtungssystems, das auf einem DALI-Netzwerk implementiert ist, wobei hierbei die Kommunikation eines DALI-Interfaces über das DALI-Netzwerk mit mehreren verteilt angeordneten Verbrauchern thematisiert wird.

Die DE 10 2016 205 683 A1 zeigt ein Fahrzeugscheinwerfersystem mit einer Mastersteuervorrichtung und mindestens einer Slavesteuervorrichtung, wobei die zumindest eine Slavesteuervorrichtung über ein Bus-System mit der Mastersteuervorrichtung verbunden ist und für das Betreiben jeweils zugeordneter Leuchtmittel verantwortlich ist.

Aus der WO 2010/043263 A1 ist eine Schnittstellenvorrichtung für ein DALI-System und ein Verfahren zu dessen Überwachung bekannt.

Die DE 102 2007 051 143 A1 zeigt ein Überwachungsgerät und ein Verfahren zum Überwachen von programmierbaren Leuchten.

Der Erfindung liegt die Aufgabe zugrunde, ein Testgerät, respektive ein Verfahren zur Überprüfung des Vorhandenseins und/oder der Funktionalität von Komponenten der Leuchte anzugeben.

Diese Aufgabe wird durch ein Verfahren gemäß dem unabhängigen Anspruch 1 und durch ein Testgerät gemäß dem unabhängigen Anspruch 10 gelöst. Besondere Ausführungsarten der Erfindung sind in den abhängigen Ansprüchen angegeben.

Gemäß der Erfindung ist ein Verfahren für einen Leuchten-Prüfvorgang zur Überprüfung einer Leuchte hinsichtlich des Vorhandenseins und/oder der Funktionalität von Komponenten der Leuchte vorgesehen. Die Leuchte weist hierbei Komponenten wie eine Steuereinheit, Leuchtmittel mit Leuchtmitteltreibern, sowie ein Bussystem, wobei das Bussystem die Komponenten der Leuchte miteinander verbindet, auf. Das Verfahren ist dadurch gekennzeichnet, dass die Buskommunikation der Leuchte überwacht wird und basierend auf Bussignalen der überwachten Buskommunikation das Vorhandensein und/oder die Funktionalität der Komponenten der Leuchte erkannt wird.

Ferner wird erfindungsgemäß ein Testgerät zur Überprüfung von Leuchten hinsichtlich des Vorhandenseins und/oder der Funktionalität von Komponenten der Leuchte in einem Leuchten-Prüfvorgang vorgeschlagen. Das Testgerät ist hierbei mit einer Busschnittstelle zur Kopplung mit dem Bussystem der Leuchte ausgebildet, wobei das Testgerät zur Überwachung der Buskommunikation der Leuchte ausgebildet ist, und weiterhin ausgebildet ist basierend auf Bussignalen der überwachten Buskommunikation das Vorhandensein und/oder die Funktionalität der Komponenten der Leuchte zu erkennen.

Durch ein derartiges Verfahren für einen Leuchten-Prüfvorgang zur Überprüfung einer Leuchte ist eine besonders einfache und kostengünstige Art und Weise der Überprüfung der Funktionalität der Leuchte bzw. des Vorhandenseins und/oder der Funktionalität von Komponenten der Leuchte gegeben. Ebenso wird durch die Ausgestaltung des Testgeräts die Erfassung der Information über die Funktionalität der Leuchte bzw. über das Vorhandensein und/oder die Funktionalität von Komponenten der Leuchte vereinfacht. Das erfindungsgemäße Testgerät ist hierbei besonders geeignet zur Durchführung des vorgeschlagenen Verfahrens für einen Leuchten-Prüfvorgang. Die Vereinfachung der Überprüfung der Leuchte hat zur Folge, dass Leuchten durch das erfindungsgemäße Verfahren und insbesondere durch das erfindungsgemäße Testgerät besonders zeit- und kosteneffizient überprüft werden können.

Eine besonders vorteilhafte Ausführung der Erfindung ist dadurch gegeben, dass im Verfahren die zu überprüfende Leuchte noch weitere Komponenten, insbesondere Sensoren und/oder Bedienelemente, als Komponenten der Leuchte umfasst, wobei diese bevorzugt ebenfalls am Bussystem angeschlossen sind.

Durch eine derartige Ausgestaltung der Leuchte kann im Verfahren auch die Funktionalität und/oder das Vorhandensein entsprechender Sensoren und/oder Bedienelemente in kurzer Zeit ohne weiteres erkannt werden, da diese ebenfalls an der Buskommunikation über das Bussystem der Leuchte teilnehmen. Hierbei sind die Sensoren und/oder Bedienelemente bevorzugt derart ausgestaltet, dass sie selbständig mit dem Bussystem kommunizieren können. Beispielsweise kann eine Leuchte mit einem Anwesenheits-, Bewegungs- und/oder Helligkeitssensor ausgestattet sein, wobei hierdurch ein selbstständiger Leuchtenbetrieb realisierbar ist, sodass die Leuchte selbstständig auf Änderungen in der Umgebung reagiert. Ebenso sind Leuchten mit Bedienelementen wie beispielsweise Schalterelementen zur Helligkeitseinstellung denkbar, sodass ein Benutzer gezielt Änderungen in der Lichtabgabe der Leuchte vornehmen kann.

Gemäß einer weiteren Ausführungsform der Erfindung für einen Leuchten-Prüfvorgang ist das Verfahren dadurch gekennzeichnet, dass bei der Überwachung der Buskommunikation die die Bussignale aussendenden Komponenten der Leuchte unterschieden werden und basierend auf der jeweiligen Buskommunikation das Vorhandensein und/oder die Funktionalität der jeweiligen Komponente erkannt wird.

Hierdurch werden in der Buskommunikation beispielsweise verschiedene Sensoren und/oder Bedienelemente oder andere Komponenten unterschieden, sodass eine Buskommunikation eindeutig einer jeweiligen Komponente zugeordnet wird, wodurch im Leuchten-Prüfvorgang beispielsweise mehrere Leuchtmittel mit Leuchtmitteltreibern voneinander unterschieden und jeweils das Vorhandensein und/oder die Funktionalität einzeln erkannt wird.

Weiterhin besonders bevorzugt ausgeführt ist die Erfindung dadurch, dass das Bussystem der Leuchte ein DALI Bussystem ist.

Besonders bevorzugt ist die Erfindung derart ausgebildet, dass die Buskommunikation der Leuchte über eine Leuchtenbusschnittstelle der Leuchte überwacht wird, wobei die Leuchtenbusschnittstelle bevorzugt eine DALI Schnittstelle ist.

In einer weiteren Ausführungsform ist die Erfindung für einen Leuchten-Prüfvorgang dadurch gekennzeichnet, dass ein Bus-Konverter-Modul an die Leuchtenbusschnittstelle der Leuchte angeschlossen wird, wobei das Bus-Konverter-Modul eine erste und eine zweite Busschnittstelle aufweist, wobei die Leuchtenbusschnittstelle mit einer zweiten Busschnittstelle des Bus-Konverter-Moduls verbunden wird, derart, dass das Bussystem der Leuchte in einem vom Bussystem der Leuchte abweichenden Busstandard zugänglich ist.

Durch eine derartige Ausführungsform wird bewerkstelligt, dass die Buskommunikation einer Leuchte, mit einem Busstandard, beispielsweise einem unüblichen Busstandard, in eine Buskommunikation mit einem gängigen Busstandard konvertiert wird, sodass die Buskommunikation von Leuchten mit beliebigen Busstandards überwacht werden kann.

Eine besonders geeignete Ausführung der Erfindung ist dadurch gegeben, dass die Leuchte über eine Netzspannungsschnittstelle mit einer Netzspannung versorgt wird, wobei bevorzugt die Leuchte über die Netzspannungsschnittstelle mit dem Testgerät gekoppelt ist, wobei das Testgerät die Netzspannungsversorgung steuert.

Durch eine derartige Ausgestaltung ist es im Verfahren ermöglicht die Netzspannung der Leuchte zu beeinflussen, bzw. die Netzspannung der Leuchte an und/oder auszuschalten, wobei bevorzugt das Testgerät selbst diese Steuerung vornimmt. Somit ist die Leuchte lediglich an das Prüfgerät zu koppeln, was einer besonders einfachen Installation des Testgeräts zur Durchführung entspricht, und zusätzlich das Testgerät dazu befähigt die Versorgungsspannung der Leuchte zu beeinflussen.

Weiterhin bevorzugt ist die Erfindung dadurch gekennzeichnet, dass die Komponenten der Leuchte sich mit Anliegen einer Netzspannung aktivieren, und Bussignale über das Bussystem schicken können.

In einer weiteren Ausführung der Erfindung wird das Ergebnis des Leuchten-Prüfvorgangs über ein Ausgabemittel ausgegeben.

Hierdurch kann besonders einfach und schnell das Ergebnis des Leuchten-Prüfvorgangs angezeigt werden, wobei keine weiteren speziellen Bediengeräte und/oder spezielle Software benötigt wird. Ebenso bedarf es keiner speziellen Schulung von Fachkräften zur Ermittlung des Ergebnisses des Leuchten-Prüfvorgangs, wodurch das Verfahren für einen Leuchten-Prüfvorgang zur Überprüfung einer Leuchte besonders kosteneffizient und zeitsparend ist.

Gemäß einer weiteren Ausführungsform der Erfindung ist das Testgerät dadurch gekennzeichnet, dass das Testgerät eine Stromversorgungsschnittstelle zur Versorgung der Leuchte mit einer Netzspannung aufweist.

Durch eine derartige Ausführung ist das Testgerät derart ausgebildet, dass eine zu überprüfende Leuchte an die Stromversorgungsschnittstelle angeschlossen werden kann, wobei das Testgerät die zu überprüfende Leuchte mit einer Netzspannung versorgen kann, und diese Netzspannung selbstständig an und/oder ausschalten kann. Dies ist zudem besonders vorteilhaft in Kombination mit der Busschnittstelle des Testgeräts, wodurch das Testgerät über die Stromversorgungsschnittstelle als auch über die Busschnittstelle mit der zu überprüfenden Leuchte gekoppelt wird, wodurch der Leuchten-Prüfvorgang besonders einfach ausgestaltet ist.

Besonders bevorzugt ist das Testgerät derart ausgebildet, den Leuchten-Prüfvorgang mittels Einschalten der Netzspannung der Leuchte zu starten.

Hierdurch ist das Testgerät vorteilhaft ausgebildet, da ermöglicht ist, dass der Leuchten-Prüfvorgang mit dem Startprozess der Leuchte startet, sodass die Buskommunikation der Leuchte mit dem Starten der Leuchte überwacht wird. Hierdurch wird eine besonders schnelle und einfache Überprüfung durch das Testgerät bewerkstelligt, wobei das Testgerät die Versorgung der Leuchte mit der Netzspannung bevorzugt über die Stromversorgungsschnittstelle einschaltet, wodurch die zu überprüfende Leuchte eingeschaltet wird, und wobei die Buskommunikation mittels der Kopplung des Testgeräts an das Bussystem der Leuchte überwacht wird.

Weiterhin vorteilhaft ist das Testgerät dadurch gekennzeichnet, dass die Busschnittstelle des Testgeräts einen gleichen Busstandard wie das Bussystem der Leuchte aufweist.

Durch eine derartige Ausbildung des Testgeräts ist eine besonders einfache Kopplung des Testgeräts mit der Leuchte ermöglicht. Ebenfalls ist denkbar, dass sofern die Busschnittstelle des Testgeräts einen unterschiedlichen Busstandard wie das Bussystem der Leuchte aufweist, ein Bus-Konverter-Modul zwischen das Testgerät und die Leuchte geschalten wird, derart, dass die erste Busschnittstelle des Bus-Konverter-Moduls mit der Busschnittstelle des Testgeräts gekoppelt ist, und die zweite Busschnittstelle des Bus-Konverter-Moduls mit dem Bussystem der Leuchte gekoppelt ist, sodass das Testgerät auch in einem derartigen Szenario die Buskommunikation der Leuchte überwachen kann, und basierend auf der Buskommunikation das Vorhandensein und/oder die Funktionalität der Komponenten der Leuchte erkennt.

Eine besonders bevorzugte Ausführung des Testgeräts ist dadurch gegeben, dass das Testgerät Ausgabemittel zur Anzeige der Ergebnisse des Leuchten-Prüfvorgangs aufweist.

Durch eine derartige Ausgestaltung ist bewerkstelligt, dass Ergebnisse des Leuchten-Prüfvorgangs in besonders einfacher Weise dargestellt werden, wobei für eine Fachkraft das Ergebnis besonders schnell und ohne weiteres Zutun ablesbar ist. Daher ist diese Ausführungsform besonders bevorzugt, da es keiner speziellen Befähigung einer Fachkraft bedarf, um das Ergebnis des Leuchten-Prüfvorgangs zu ermitteln.

In einer weiteren bevorzugten Ausführungsform ist das Testgerät reversibel mit der Leuchte verbindbar, sodass in besonders einfacher Weise das Testgerät mit der zu überprüfenden Leuchte gekoppelt und entkoppelt werden kann. Dies vereinfacht den Leuchten-Prüfvorgang erheblich.

Die Erfindung wird im Folgenden anhand von Ausführungsbeispielen und mit Bezug auf die Zeichnung näher erläutert. Es zeigen:
- Fig. 1: Beispielhafte Ausführung eines Leuchten-Prüfvorgangsaufbaus mit einer Ausführung eines erfindungsgemäßen Testgeräts und einer zu überprüfenden Leuchte;
- Fig. 2: Weitere beispielhafte Ausführung eines Leuchten-Prüfvorgangsaufbaus mit einer Ausführung eines erfindungsgemäßen Testgeräts, welches über ein zwischengeschaltetes Bus-Konverter-Modul mit der zu überprüfenden Leuchte gekoppelt ist;
- Fig. 3: Beispielhafte Darstellung einer Ausführung des erfindungsgemäßen Verfahrens für einen Leuchten-Prüfvorgang zur Überprüfung einer Leuchte hinsichtlich des Vorhandenseins und/oder der Funktionalität von Komponenten der Leuchte, mittels einer Ausführungsform eines erfindungsgemäßen Testgeräts;
- Fig. 4: Beispielhafte Darstellung einer durch ein erfindungsgemäßes Testgerät erfassten und überwachten Buskommunikation einer zu überprüfenden Leuchte in einem Leuchten-Prüfvorgang.

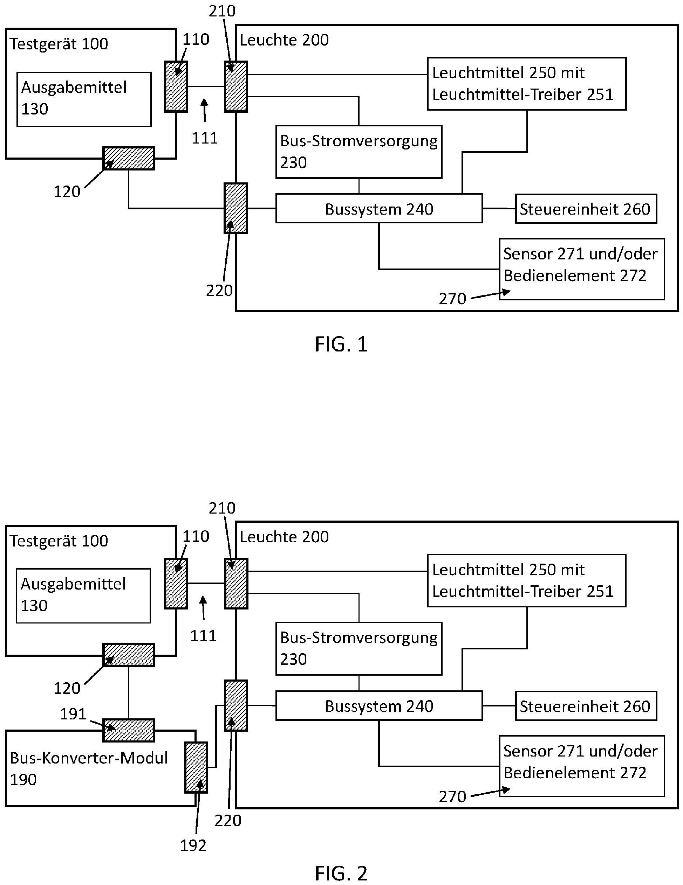

Figur 1 zeigt den Aufbau eines Testgeräts 100 mit einer Leuchte 200 skizzenhaft mit den jeweiligen einzelnen Komponenten sowohl des Testgeräts 100 als auch der Leuchte 200. Das Testgerät 100 ist derart ausgebildet, den Leuchten-Prüfvorgang der Leuchte 200 durchzuführen.

Das Testgerät ist hierbei mit zwei Schnittstellen 110, 120 ausgebildet, genauer weist das Testgerät 100 eine Stromversorgungsschnittstelle 110 zur Versorgung der Leuchte 200 mit einer Netzspannung 111 und eine Busschnittstelle 120 zur Kopplung mit dem Bussystem 240 der Leuchte 200 auf. Ebenso verfügt das Testgerät 100 über Ausgabemittel 130 zur Anzeige der Ergebnisse des Leuchten-Prüfvorgangs.

Die mit dem Testgerät gekoppelte Leuchte 200 weist eine Netzspannungsschnittstelle 210 auf, worüber die Leuchte 200 mit einer Netzspannung 111 durch das Testgerät 100 versorgt wird. Zudem ist die Leuchte 200 mit einer Leuchtenbusschnittstelle 220 ausgebildet, wobei das Testgerät 100 an die Leuchtenbusschnittstelle 220 angeschlossen ist und so mit dem Bussystem 240 gekoppelt ist. Beispielsweise ist die Leuchtenbusschnittstelle 220 als Zhaga-Schnittstelle ausgeführt. Ebenso verfügt die Leuchte 200 über eine Bus-Stromversorgung 230, wobei die Bus-Stromversorgung 230 mit dem Bussystem 240 der Leuchte 200 verbunden ist. Die Netzspannungsschnittstelle 210 der Leuchte ist zum einen mit der Bus-Stromversorgung 230, als auch mit Leuchtmitteln 250 mit Leuchtmitteltreiber 251 verbunden, wobei die Leuchtmitteln 250 mit Leuchtmitteltreiber 251 ebenso mit dem Bussystem 240 verbunden sind.

Die Leuchte 200 weist in der dargestellten bevorzugten Ausführungsform ebenso weitere Komponenten 270 auf, insbesondere zumindest einen Sensor 271 und/oder zumindest ein Bedienelement 272, wobei diese weitere Komponenten 270 ebenso mit dem Bussystem 240 gekoppelt sind. Üblicherweise werden derartige Leuchten 200 beispielsweise mit zumindest einem Anwesenheits-, Bewegungs- und/oder Helligkeitssensor ausgestattet, wobei hierdurch ein selbstständiger Leuchtenbetrieb realisierbar ist, sodass die Leuchte 200 selbstständig auf Änderungen in der Umgebung reagiert. Ebenso ist es denkbar, dass Leuchten 200 mit Bedienelementen 272 wie beispielsweise Schalterelementen zur Helligkeitseinstellung ausgestattet sind, sodass beispielsweise ein Benutzer gezielt Änderungen in der Lichtabgabe der Leuchte 200 vornehmen kann. Die genannten Ausführungsformen der weiteren Komponenten 270, respektive der Sensoren 271 und/oder Bedienelemente 272 sind nicht auf die aufgeführten Beispiele beschränkt, wobei ebenso andere Sensoren 271 und/oder Bedienelemente 272 verwendet werden können.

Die Leuchte 200 verfügt zudem über eine Steuereinheit 260, welche ebenfalls mit dem Bussystem 240 verbunden ist, wobei die Steuereinheit 260 den Betrieb der Leuchte 200 und ihre Komponenten steuert.

Die Komponenten der Leuchte 200, welche über das Bussystem 240 der Leuchte 200 miteinander verbunden sind, können über dieses Bussystem 240 eine Buskommunikation untereinander aufbauen, wobei Bussignale von den einzelnen Komponenten sowohl versendet als auch empfangen werden können.

Bevorzugt ist vorgesehen, dass die Leuchte 200 mit Anliegen einer Netzspannung 111 sich anschaltet, wobei die einzelnen Komponenten der Leuchte 200 sich ebenso anschalten, bzw. aktivieren, und Bussignale über das Bussystem 240 schicken.

In einer weiteren Ausführungsform ist hierbei vorgesehen, dass die Komponenten der Leuchte 200 von sich selbständig im Anschaltvorgang der Leuchte 200 ihren Status über das Bussystem 240 senden.

In einer weiteren Ausführungsform kann vorgesehen sein, dass die Steuereinheit 260 die einzelnen Komponenten der Leuchte 200 jeweils über ein Bussignal ansteuert, und dadurch eine Rückmeldung der einzelnen Komponenten in der Leuchte 200 erhält.

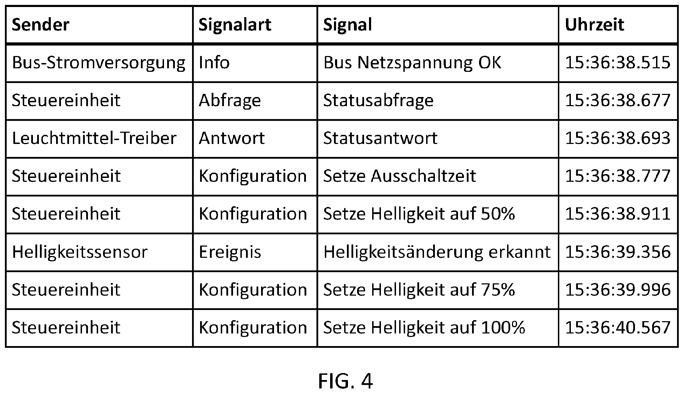

Das Testgerät 100, welches mit der Leuchte 200, insbesondere mit der Leuchtenbusschnittstelle 220, über die Busschnittstelle 120 gekoppelt ist, ist dazu ausgebildet, während der Startphase der Leuchte 200, die Buskommunikation des Bussystems 240 der Leuchte 200 zu überwachen, und ist weiterhin ausgebildet, basierend auf den Bussignalen der überwachten Buskommunikation das Vorhandensein und/oder die Funktionalität der Komponenten der Leuchte 200 zu erkennen. Eine beispielhafte Darstellung einer durch ein Testgerät 100 erfassten und überwachten Buskommunikation einer zu überprüfenden Leuchte 200 in einem Leuchten-Prüfvorgang ist in Figur 4 dargestellt.

Besonders bevorzugt ist hierbei vorgesehen, dass das Testgerät 100 den Leuchten-Prüfvorgang mittels Einschalten der Netzspannung 111 der Leuchte 200 über die Stromversorgungsschnittstelle 110 startet, sodass das Testgerät 100 die Buskommunikation des Bussystems 240 im gesamten Leuchten-Prüfvorgang erfasst, wobei insbesondere das Einschalten der Leuchte 200 und das Aktivieren der einzelnen Komponente der Leuchte 200 über das Bussystem durch das Testgerät 100 registriert wird.

In der Figur 1 ist eine Ausführungsform dargestellt, in welcher das Testgerät 100 und die Leuchte 200, respektive die Busschnittstelle 120 des Testgeräts 100 und die Leuchtenbusschnittstelle 220 der Leuchte 200 einen gleichen Busstandard aufweisen, sodass sie direkt miteinander gekoppelt sind, wobei mittels dieser Kopplung die Buskommunikation der Leuchte 200 durch das Testgerät 100 überwacht wird. Weiterhin bevorzug wird im Bussystem 240 der DALI Busstandard verwendet, sodass das Bussystem 240 der Leuchte 200 ein DALI-Bussystem ist.

In der in Figur 1 dargestellten besonders bevorzugten Ausführungsform des Testgeräts 100 weist das Testgerät 100 Ausgabemittel 130 zur Anzeige der Ergebnisse des Leuchten-Prüfvorgangs auf. Hierbei kann insbesondere vorgesehen sein, dass die Überprüfungsergebnisse einzelner Komponenten jeweils über die Ausgabemittel angezeigt werden. Ebenso ist es denkbar, dass das Testgerät nach Abschluss des Leuchten-Prüfvorgangs die Ergebnisse des Leuchten-Prüfvorgangs gesammelt über das Ausgabemittel anzeigt.

Im Leuchten-Prüfvorgang des in Figur 1 beispielhaft dargestellten Aufbaus eines Testgeräts 100 und einer zu überprüfenden Leuchte 200, schaltet das Testgerät 100 über die Stromversorgungsschnittstelle 110 die Netzspannung 111 ein, wodurch an der Netzspannungsschnittstelle 210 der Leuchte 200 die Netzspannung 111 anliegt und die Leuchte 200, respektive die Komponenten der Leuchte 200, sich anschalten.

Im Einschaltprozess der Leuchte 200 senden die Komponenten der Leuchte 200 Bussignale über das Bussystem 240. Hierbei ist es denkbar, dass die jeweiligen Komponenten der Leuchte 200 von sich aus ihre Betriebsbereitschaft mittels eines Bussignals signalisieren, und/oder durch ein Bussignal einer anderen Komponente, insbesondere durch ein Bussignal der Steuereinheit 260, aufgefordert werden ihren Status über ein Bussignal zu signalisieren. In beiden Fällen wird hierbei die Buskommunikation durch das Testgerät 100 überwacht und erkannt.

Über die Kopplung des Testgeräts 100 an das Bussystem 240 der Leuchte 200 überwacht das Testgerät 100 bereits den Einschaltprozess der Leuchte 200, wobei das Testgerät 100 derart ausgebildet ist, die Bussignale der Komponenten der Leuchte 200 voneinander zu unterscheiden, wobei das Testgerät 100 basierend auf der jeweiligen Buskommunikation das Vorhandensein und/oder die Funktionalität der jeweiligen Komponente erkennt.

Es ist hierbei einerseits denkbar, dass das Testgerät 100 den Leuchten-Prüfvorgang nach Ablauf einer bestimmten Zeit beendet und das Ergebnis über die Ausgabemittel 130 darstellt. Ebenso ist es denkbar, dass das Testgerät 100 selbstständig erkennt, wenn alle Komponenten der Leuchte 200 ein Bussignal über das Bussystem 240 verschickt haben, wobei es ebenso denkbar ist, dass das Testgerät 100 auch Bussignale welche auf das Fehlen und/oder auf eine fehlerhafte Funktion einer Komponente der Leuchte 200 hinweisen, erkennt und entsprechend im Ergebnis des Leuchten-Prüfvorgangs darstellt.

Hierdurch lässt sich die Funktionalität einer Leuchte 200, respektive die Funktionalität und/oder das Vorhandensein von Komponenten einer Leuchte 200, in besonders einfacher Weise erkennen, wobei ein Testgerät 100 zur Durchführung des Leuchten-Prüfvorgangs verwendet wird. Das Testgerät 100 ist dabei derart ausgebildet, in einem Leuchten-Prüfvorgang das Ergebnis der Überprüfung der Leuchte 200 einfach und schnell zu erfassen. Besonders bevorzugt läuft der Leuchten-Prüfvorgang hierbei automatisiert ab, sodass es keiner Eingaben oder Betätigungen durch eine Fachkraft bedarf. Ebenso ist es allerdings denkbar ist, dass der Leuchten-Prüfvorgang durch ein manuelles initiieren, beispielsweise durch ein manuelles Betätigen einer weiteren Komponente 270, wie beispielsweise durch ein Auslösen eines Sensors 271 oder einer Bedienung eines Bedienelements 272. Weiterhin kann vorgesehen sein, dass einzelne Verfahrensschritte des Leuchten-Prüfvorgangs durch ein derartiges manuelles Betätigen einer weiteren Komponente 270 initiiert werden. Darüber hinaus ist es ebenso denkbar, dass das Testgerät 100 über zusätzliche Elemente, wie beispielsweise ein Bedienelement oder einen Sensor verfügt, worüber ebenso der Leuchten-Prüfvorgang initiiert wird, und/oder worüber einzelne Verfahrensschritte des Leuchten Prüfvorgangs initiiert werden.

Ebenso ist der Aufbau des Leuchten-Prüfvorgangs reversibel, sodass die Verbindung des Testgeräts 100 mit der Leuchte 200 reversibel gestaltet ist, wobei das Testgerät 100 nach Durchlaufen des Leuchten-Prüfvorgangs von der Leuchte 200 entkoppelt werden kann.

In Figur 2 ist ein ähnlicher Aufbau für einen Leuchten-Prüfvorgang wie aus Figur 1 dargestellt, wobei das Testgerät 100 und die Leuchte 200 sich hierbei im jeweils vorhandenen Busstandard unterscheiden, sodass das Bussystem 240 der Leuchte 200, respektive die Leuchtenbusschnittstelle 220 der Leuchte 200 einen anderen Busstandard aufweist als die Busschnittstelle 120 des Testgeräts 100. In der dargestellten Ausführungsform ist ein Bus-Konverter-Modul 190 zwischen das Testgerät 100 und die Leuchte 200 respektive zwischen die Busschnittstelle 120 des Testgeräts 100 und die Leuchtenbusschnittstelle 220 der Leuchte 200, gekoppelt. Hierbei ist die Busschnittstelle 120 des Testgeräts 100 mit einer ersten Busschnittstelle 191 des Bus-Konverter-Moduls 190 verbunden, und die Leuchtenbusschnittstelle 220 der Leuchte 200 ist mit einer zweiten Busschnittstelle 192 des Bus-Konverter-Moduls 190 verbunden. Das Bus-Konverter-Modul 190 konvertiert hierbei den vom Testgerät 100 sich unterscheidenden Busstandard des Bussystems 240 der Leuchte auf den Busstandard des Testgeräts 100, sodass das Testgerät 100 auch in dieser Ausführungsform die Buskommunikation des Bussystems 240 der Leuchte 200 über die Leuchtenbusschnittstelle 220 überwachen kann.

Die Ausführungsform mit dem Bus-Konverter-Modul 190 ermöglicht somit eine universelle Anwendbarkeit des Testgeräts 100 mit Leuchten 200, wobei die Leuchten 200 auch vom Testgerät unterschiedliche Busstandards aufweisen können. Das Verfahren für den Leuchten-Prüfvorgang unterscheidet sich in dieser Ausführungsform nicht vom Leuchten-Prüfvorgang des in Figur 1 dargestellten Aufbaus.

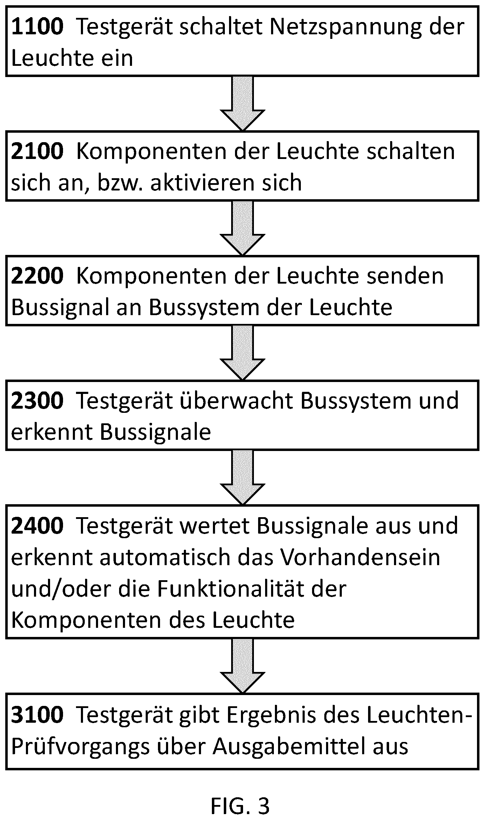

In Figur 3 ist eine Ausführungsform des Verfahrens für einen Leuchten-Prüfvorgang zur Überprüfung einer Leuchte 200 hinsichtlich des Vorhandenseins und/oder der Funktionalität von Komponenten der Leuchte 200 gezeigt, wobei die Leuchte 200 Komponenten wie eine Steuereinheit 260, Leuchtmittel 250 mit Leuchtmitteltreiber 251, sowie ein Bussystem 240, wobei das Bussystem 240 die Komponenten der Leuchte 200 miteinander verbindet, aufweist. Exemplarisch wird in dem in der Figur 3 dargestellten Verfahren der Leuchten-Prüfvorgang für den in Figur 1 gezeigten Aufbau beschrieben.

In einem ersten Verfahrensschritt 1100 schaltet ein Testgerät 100 die Netzspannung 111 der Leuchte 200 ein, wobei die Leuchte 200 bevorzugt über die Netzspannungsschnittstelle 210 mit der Stromversorgungsschnittstelle 110 des Testgeräts 100 verbunden ist. Ebenso ist das Bussystem 240 der Leuchte 200 über die Leuchtenbusschnittstelle 220 mit der Busschnittstelle 120 des Testgeräts 100 gekoppelt. Ebenso ist es denkbar, dass die Netzspannung 111 nicht durch das Testgerät 100 eingeschaltet wird, wobei die Leuchte 200 anderweitig mit einer Netzspannung 111 versorgt wird.

In der dargestellten Ausführungsform des Leuchten-Prüfvorgangs startet der Leuchten-Prüfvorgang mit dem Einschaltvorgang der Leuchte 200, wobei es ebenso denkbar ist, dass der Leuchten-Prüfvorgang mit Betätigung eines Bedienelements 272 und/oder durch das Auslösen eines Sensors 271 initiiert wird.

Im nachfolgenden Verfahrensschritt 2200 aktivieren sich die Komponenten der Leuchte 200 und senden jeweils Bussignale über das Bussystem 240 der Leuchte 200. Das Testgerät 100 überwacht hierbei die Buskommunikation und erkennt und registriert somit auch die einzelnen Bussignale der jeweiligen Komponenten (Verfahrensschritt 2300). Daraufhin wertet das Testgerät 100 die überwachten und registrierten Bussignale aus und erkennt - bevorzugt automatisch - das Vorhandensein und/oder die Funktionalität der Komponenten der Leuchte 200 (Verfahrensschritt 2400).

Im Anschluss an die Auswertung gibt das Testgerät 100 das Ergebnis des Leuchten-Prüfvorgangs über die Ausgabemittel 130 aus (Verfahrensschritt 3100), wodurch in besonders einfacher und zeitsparender Weise die Funktionalität und/oder das Vorhandensein von Komponenten einer Leuchte 200 erkennbar ist.

Figur 4 zeigt exemplarisch eine Ausführung der durch das Testgerät 100 erfassten und überwachten Bussignale der Buskommunikation des Bussystems 240 der Leuchte 200 während eines Start- bzw. Aktivierungsprozesses der Komponenten der Leuchte 200. Im dargestellten Ausschnitt der überwachten Buskommunikation ist beispielhaft dargestellt, welche Informationen das Testgerät 100 basierend auf der Buskommunikation erhält, wobei Informationen hinsichtlich des Absenders des Bussignals, der Signalart des Bussignals, die Signalinformation des Bussignals und der Zeitstempel des Bussignals im Ausführungsbeispiel der Figur 4 dargestellt wird. Ebenso ist es denkbar, dass andere Informationen dem Bussignal enthalten sind, wobei das Testgerät 100 ausgebildet ist, auch diese anderen Informationen des Bussignals zu empfangen und zu überwachen. In einer anderen Ausführungsform ist es denkbar, dass die Bussignale anstatt der wie in Figur 4 exemplarisch dargestellten Uhrzeit Information beispielsweise die Systemzeit der Leuchte 200 in den Bussignalen der Buskommunikation als Information enthalten ist. Hierbei kann vorgesehen sein, dass die Systemzeit jeweils mit dem Einschaltvorgang startet. Grundlegend ist, dass das Testgerät 100 stets derart ausgebildet ist, dass es den typische Aktivierungsprozess der Komponenten der Leuchte 200 überwacht, und die jeweiligen Bussignale der Buskommunikation registriert.

In dem dargestellten Abschnitt der Buskommunikation, welcher exemplarisch lediglich zwei Sekunden der Buskommunikation darstellt, sind unterschiedliche Bussignale von unterschiedlichen Komponenten der Leuchte 200 aufgeführt, wobei im Leuchten-Prüfvorgang das erfindungsgemäße Testgerät 100 die unterschiedlichen Bussignale der Buskommunikation analysiert und basierend darauf das Vorhandensein und/oder die Funktionalität der einzelnen Komponenten der Leuchte 200 erkennt. Im exemplarischen Ausschnitt der vom Testgerät 100 überwachten Buskommunikation sind typische Bussignale im Start- bzw. Aktivierungsprozess der Leuchte 200 dargestellt.

Beispielsweise erkennt das Testgerät in der in der Figur 4 dargestellten Ausführung der Buskommunikation, dass eine Bus-Stromversorgung 230 vorhanden ist und dass diese ordnungsgemäß funktioniert, sowie dass eine Steuereinheit 260, Leuchtmitteltreiber 251, und ein Helligkeitssensor 271 vorhanden sind, wobei diese jeweils ordnungsgemäß funktionieren. Sollte beispielsweise ein Bussignal mit fehlerhaften Informationen oder beispielsweise mit Fehlermeldungen in der überwachten Buskommunikation enthalten sein, so würde das Testgerät 100 ebenfalls erkennen, dass die Funktionalität von Komponenten der Leuchte 200 nicht gegeben ist.

Ebenso würde beispielsweise ein Nicht-Vorhandensein eines Bussignals einer Komponente des Bussystems 240 der Leuchte 200 zu einem entsprechenden Ergebnis hinsichtlich des Vorhandenseins und/oder der Funktionalität der jeweiligen Komponente des Bussystems 240 der Leuchte 200 führen. Dies könnte gemäß einer weiteren Ausführungsform derart festgestellt werden, dass das Testgerät 100, während des Überwachens des typischen Aktivierungsprozesses der Komponenten der Leuchte 200, ein Bussignal der Steuereinheit 260 mitliest, in der die Steuereinheit 260 eine andere Komponente des Bussystems 240 der Leuchte 200 auffordert den Status anzugeben, wobei eine Statusantwort der entsprechenden Komponente ausbleibt. Ebenso ist es denkbar, dass im Testgerät 100 Informationen zur überprüfenden Leuchte 200 hinterlegt sind, sodass das Testgerät 100 durch Abgleich mit diesen Informationen erkennt, ob alle zu erwartenden Komponenten der Leuchte 200 an der Buskommunikation teilnehmen.

Das Testgerät 100, respektive das Verfahren für einen Leuchten-Prüfvorgang, erlaubt somit eine besonders schnelle und einfache Überprüfung einer Leuchte 200 hinsichtlich des Vorhandenseins und/oder der Funktionalität von Komponenten der Leuchte 200. Das Testgerät 100, respektive das Verfahren zur Überprüfung, ist zudem durch die Einfachheit der Durchführung des Prüfvorgangs gekennzeichnet, wobei sich dies positiv auf die Kosten des Prüfvorgangs auswirkt, da keine weiteren speziellen Prüfgeräte und/oder Betriebsgeräte mit der zu überprüfenden Leuchte 200 zu koppeln sind, wobei zudem auch keine speziell ausgebildete Fachkraft benötigt wird, um den Leuchten-Prüfvorgang durchzuführen. Ebenso wird der Kostenfaktor Zeit durch die Verwendung des Testgeräts 100, respektive des Verfahrens für den Leuchten-Prüfvorgang, reduziert, da die Überprüfung nun lediglich wenige Sekunden benötigt und bevorzugt automatisiert abläuft. Zudem wird das Ergebnis des Leuchten-Prüfvorgangs bevorzugt über die Ausgabemittel 130 angezeigt, wodurch eine schnelle und unkomplizierte Ergebnisauswertung gegeben ist.

## Patentansprüche

1. Verfahren für einen Leuchten-Prüfvorgang zur Überprüfung einer Leuchte (200) hinsichtlich des Vorhandenseins und/oder der Funktionalität von Komponenten der Leuchte (200), wobei die Leuchte (200) Komponenten wie eine Steuereinheit (260), Leuchtmittel (250) mit Leuchtmitteltreiber (251), sowie ein Bussystem (240), wobei das Bussystem (240) die Komponenten der Leuchte miteinander verbindet, aufweist,
**dadurch gekennzeichnet,**
**dass** die Buskommunikation der Leuchte (200) überwacht wird und basierend auf Bussignalen der überwachten Buskommunikation das Vorhandensein und/oder die Funktionalität der Komponenten der Leuchte (200) erkannt wird, wobei ein Testgerät (100) zur Durchführung des Leuchten-Prüfvorgangs verwendet wird.

2. Verfahren nach Anspruch 1,
**dadurch gekennzeichnet,**
**dass** die zu überprüfende Leuchte (200) noch weitere Komponenten (270), insbesondere Sensoren (271) und/oder Bedienelemente (272), als Komponenten der Leuchte (200) umfasst, wobei diese bevorzugt ebenfalls am Bussystem (240) angeschlossen sind.

3. Verfahren nach Anspruch 1 oder 2,
**dadurch gekennzeichnet,**
**dass** bei der Überwachung der Buskommunikation die die Bussignale aussendenden Komponenten der Leuchte (200) unterschieden werden und basierend auf der jeweiligen Buskommunikation das Vorhandensein und/oder die Funktionalität der jeweiligen Komponente erkannt wird.

4. Verfahren nach einem der vorherigen Ansprüche,
**dadurch gekennzeichnet,**
**dass** das Bussystem (240) der Leuchte (200) ein DALI-Bussystem ist.

5. Verfahren nach einem der vorherigen Ansprüche,
**dadurch gekennzeichnet,**
**dass** die Buskommunikation der Leuchte (200) über eine Leuchtenbusschnittstelle (220) der Leuchte (200) überwacht wird, wobei die Leuchtenbusschnittstelle (220) bevorzugt eine DALI-Schnittstelle ist.

6. Verfahren nach Anspruch 5,
**dadurch gekennzeichnet,**
**dass** ein Bus-Konverter-Modul (190) an die Leuchtenbusschnittstelle (220) der Leuchte (200) angeschlossen wird, wobei das Bus-Konverter-Modul (190) zumindest einer erste und eine zweite Busschnittstellen (191, 192) aufweist, wobei die Leuchtenbusschnittstelle (220) mit einer zweiten Busschnittstelle (192) des Bus-Konverter-Moduls (190) verbunden wird, derart, dass das Bussystem (240) der Leuchte (200) in einem vom Bussystem (240) der Leuchte (200) abweichenden Busstandard zugänglich ist.

7. Verfahren nach einem der vorherigen Ansprüche,
**dadurch gekennzeichnet,**
**dass** die Leuchte (200) über eine Netzspannungsschnittstelle (220) mit einer Netzspannung versorgt wird, wobei bevorzugt die Leuchte (200) über die Netzspannungsschnittstelle (220) mit dem Testgerät (100) gekoppelt ist, wobei das Testgerät (100) die Netzspannungsversorgung steuert.

8. Verfahren nach einem der vorherigen Ansprüche,
**dadurch gekennzeichnet,**
**dass** die Komponenten der Leuchte (200) sich mit Anliegen einer Netzspannung (111) aktivieren, und Bussignale über das Bussystem (240) schicken können.

9. Verfahren nach einem der vorherigen Ansprüche,
**dadurch gekennzeichnet,**
**dass** das Ergebnis der Überprüfung der Leuchte (200) über ein Ausgabemittel (130) ausgegeben wird.

10. Testgerät (100) zur Überprüfung von Leuchten (200) hinsichtlich des Vorhandenseins und/oder der Funktionalität von Komponenten der Leuchte (200) in einem Leuchten-Prüfvorgang,
**dadurch gekennzeichnet,**
**dass** das Testgerät (100) mit einer Busschnittstelle (120) zur Kopplung mit dem Bussystem (240) der Leuchte (200) ausgebildet ist,
wobei das Testgerät (100) zur Überwachung der Buskommunikation der Leuchte (200) ausgebildet ist, und weiterhin ausgebildet ist basierend auf Bussignalen der überwachten Buskommunikation das Vorhandensein und/oder die Funktionalität der Komponenten der Leuchte (200) zu erkennen.

11. Testgerät nach Anspruch 10,
**dadurch gekennzeichnet,**
**dass** das Testgerät (100) eine Stromversorgungsschnittstelle (110) zur Versorgung der Leuchte (200) mit einer Netzspannung (111) aufweist.

12. Testgerät nach Anspruch 11,
**dadurch gekennzeichnet,**
**dass** das Testgerät (100) derart ausgebildet ist, den Leuchten-Prüfvorgang mittels Einschalten der Netzspannung (111) der Leuchte (200) zu starten.

13. Testgerät nach einem der vorherigen Ansprüche
**dadurch gekennzeichnet,**
**dass** die Busschnittstelle (120) des Testgeräts (100) einen gleichen Busstandard wie das Bussystem (240) der Leuchte (200) aufweist.

14. Testgerät nach einem der vorherigen Ansprüche,
**dadurch gekennzeichnet,**
**dass** das Testgerät (100) Ausgabemittel (130) zur Anzeige der Ergebnisse des Leuchten-Prüfvorgangs aufweist.

15. Testgerät nach einem der vorherigen Ansprüche,
**dadurch gekennzeichnet,**
**dass** das Testgerät (100) reversibel mit der Leuchte (200) verbindbar ist.

## Claims

1. Method for a luminaire testing process for checking a luminaire (200) with regard to the presence and/or functionality of components of the luminaire (200), the luminaire (200) having components such as a control unit (260), illuminants (250) with an illuminant driver (251), and a bus system (240), the bus system (240) connecting the components of the luminaire to one another,
**characterized in that**
the bus communication of the luminaire (200) is monitored and the presence and/or functionality of the components of the luminaire (200) is detected on the basis of bus signals of the monitored bus communication, a test device (100) being used to carry out the luminaire testing process.

2. Method according to claim 1,
**characterized in that**
the luminaire (200) to be checked comprises further components (270), in particular sensors (271) and/or operating elements (272), as components of the luminaire (200), these being preferably also connected to the bus system (240).

3. Method according to claim 1 or 2,
**characterized in that**
when monitoring the bus communication, the components of the luminaire (200) that emit the bus signals are differentiated and the presence and/or functionality of the particular component is detected on the basis of the particular bus communication.

4. Method according to any of the preceding claims,
**characterized in that**
the bus system (240) of the luminaire (200) is a DALI bus system.

5. Method according to any of the preceding claims,
**characterized in that**
the bus communication of the luminaire (200) is monitored via a luminaire bus interface (220) of the luminaire (200), the luminaire bus interface (220) preferably being a DALI interface.

6. Method according to claim 5,
**characterized in that**
a bus converter module (190) is connected to the luminaire bus interface (220) of the luminaire (200), the bus converter module (190) having at least a first and a second bus interface (191, 192), the luminaire bus interface (220) being connected to a second bus interface (192) of the bus converter module (190) such that the bus system (240) of the luminaire (200) is accessible in a bus standard that differs from the bus system (240) of the luminaire (200).

7. Method according to any of the preceding claims,
**characterized in that**
the luminaire (200) is supplied with a mains voltage via a mains voltage interface (220), preferably the luminaire (200) being coupled to the test device (100) via the mains voltage interface (220), the test device (100) controlling the mains voltage supply.

8. Method according to any of the preceding claims,
**characterized in that**
the components of the luminaire (200) are activated when a mains voltage (111) is applied and can send bus signals via the bus system (240).

9. Method according to any of the preceding claims,
**characterized in that**
the result of the checking of the luminaire (200) is output via an output means (130).

10. Test device (100) for checking luminaires (200) with regard to the presence and/or functionality of components of the luminaire (200) in a luminaire testing process,
**characterized in that**
the test device (100) is has a bus interface (120) for coupling to the bus system (240) of the luminaire (200), the test device (100) being designed to monitor the bus communication of the luminaire (200), and being further designed to detect the presence and/or functionality of the components of the luminaire (200) on the basis of bus signals of the monitored bus communication.

11. Test device according to claim 10,
**characterized in that**
the test device (100) has a power supply interface (110) for supplying the luminaire (200) with a mains voltage (111).

12. Test device according to claim 11,
**characterized in that**
the test device (100) is designed to start the luminaire testing process by switching on the mains voltage (111) of the luminaire (200).

13. Test device according to any of the preceding claims,
**characterized in that**
the bus interface (120) of the test device (100) has the same bus standard as the bus system (240) of the luminaire (200).

14. Test device according to any of the preceding claims,
**characterized in that**
the test device (100) has output means (130) for displaying the results of the luminaire test process.

15. Test device according to any of the preceding claims,
**characterized in that**
the test device (100) can be reversibly connected to the luminaire (200).

## Revendications

1. Procédé pour une opération de contrôle de luminaire pour l'examen d'un luminaire (200) en ce qui concerne la présence et/ou la fonctionnalité de composants du luminaire (200), dans lequel le luminaire (200) présente des composants tels qu'une unité de commande (260), des moyens d'éclairage (250) comportant un pilote de moyens d'éclairage (251), ainsi qu'un système de bus (240), dans lequel le système de bus (240) relie entre eux les composants du luminaire,
**caractérisé en ce**
**que** la communication par bus du luminaire (200) est surveillée et, sur la base de signaux de bus de la communication par bus surveillée, la présence et/ou la fonctionnalité des composants du luminaire (200) sont reconnues, dans lequel un appareil de test (100) est utilisé pour la mise en œuvre de l'opération de contrôle de luminaire.

2. Procédé selon la revendication 1,
**caractérisé en ce**
**que** le luminaire (200) à examiner comprend encore d'autres composants (270), en particulier des capteurs (271) et/ou des éléments de commande (272), en tant que composants du luminaire (200), dans lequel ceux-ci sont de préférence également raccordés au système de bus (240).

3. Procédé selon la revendication 1 ou 2,
**caractérisé en ce**
**que,** lors de la surveillance de la communication par bus, les composants du luminaire (200) émettant les signaux de bus sont différenciés et, sur la base de la communication par bus respective, la présence et/ou la fonctionnalité du composant respectif sont reconnues.

4. Procédé selon l'une des revendications précédentes,
**caractérisé en ce**
**que** le système de bus (240) du luminaire (200) est un système de bus DALI.

5. Procédé selon l'une des revendications précédentes,
**caractérisé en ce**
**que** la communication par bus du luminaire (200) est surveillée par l'intermédiaire d'une interface de bus de luminaire (220) du luminaire (200), dans lequel l'interface de bus de luminaire (220) est de préférence une interface DALI.

6. Procédé selon la revendication 5,
**caractérisé en ce**
**qu**'un module convertisseur de bus (190) est raccordé à l'interface de bus de luminaire (220) du luminaire (200), dans lequel le module convertisseur de bus (190) présente au moins une première et une seconde interface de bus (191, 192), dans lequel l'interface de bus de luminaire (220) est reliée à une seconde interface de bus (192) du module convertisseur de bus (190), de telle sorte que le système de bus (240) du luminaire (200) est accessible dans un standard de bus différent du système de bus (240) du luminaire (200).

7. Procédé selon l'une des revendications précédentes,
**caractérisé en ce**
**que** le luminaire (200) est alimenté en tension de réseau par l'intermédiaire d'une interface de tension de réseau (220), dans lequel le luminaire (200) est de préférence accouplé à l'appareil de test (100) par l'intermédiaire de l'interface de tension de réseau (220), dans lequel l'appareil de test (100) commande l'alimentation en tension de réseau.

8. Procédé selon l'une des revendications précédentes,
**caractérisé en ce**
**que** les composants du luminaire (200) peuvent s'activer avec l'application d'une tension de réseau (111), et envoyer des signaux de bus par l'intermédiaire du système de bus (240).

9. Procédé selon l'une des revendications précédentes,
**caractérisé en ce**
**que** le résultat de l'examen du luminaire (200) est émis par l'intermédiaire d'un moyen de sortie (130).

10. Appareil de test (100) permettant d'examiner des luminaires (200) en ce qui concerne la présence et/ou la fonctionnalité de composants du luminaire (200) dans une opération de contrôle de luminaire,
**caractérisé en ce**
**que** l'appareil de test (100) est réalisé avec une interface de bus (120) pour l'accouplement avec le système de bus (240) du luminaire (200), dans lequel l'appareil de test (100) est réalisé pour la surveillance de la communication par bus du luminaire (200), et est en outre réalisé pour reconnaître la présence et/ou la fonctionnalité des composants du luminaire (200) sur la base de signaux de bus de la communication par bus surveillée.

11. Appareil de test selon la revendication 10,
**caractérisé en ce**
**que** l'appareil de test (100) présente une interface d'alimentation en courant (110) pour l'alimentation du luminaire (200) avec une tension de réseau (111).

12. Appareil de test selon la revendication 11,
**caractérisé en ce**
**que** l'appareil de test (100) est réalisé de telle sorte que l'opération de contrôle de luminaire est démarrée au moyen de la mise en circuit de la tension de réseau (111) du luminaire (200).

13. Appareil de test selon l'une des revendications précédentes
**caractérisé en ce**
**que** l'interface de bus (120) de l'appareil de test (100) présente un même standard de bus que le système de bus (240) du luminaire (200).

14. Appareil de test selon l'une des revendications précédentes,
**caractérisé en ce**
**que** l'appareil de test (100) présente des moyens de sortie (130) pour l'affichage des résultats de l'opération de contrôle de luminaire.

15. Appareil de test selon l'une des revendications précédentes,
**caractérisé en ce**
**que** l'appareil de test (100) peut être relié de manière réversible au luminaire (200).
